# EUROPEAN PATENT APPLICATION

(11) **EP 4 641 878 A1**
(43) Date of publication of application: **29.10.2025**
(21) Application number: 24216476.2
(22) Date of filing: 29.11.2024
(51) Int. Cl.: H02J 7/00

(54) **CONTACTOR CONTROL CIRCUIT AND BATTERY PACK INCLUDING THE SAME**

(30) Priority: 23.04.2024 KR 20240054266
(71) Applicant: SAMSUNG SDI CO., LTD., Yongin-si, Gyeonggi-do 17084 (KR)
(72) Inventor: Kim, Kiseon, Yongin-si, Gyeonggi-do 17084 (KR)
(74) Representative: Gulde & Partner

(57) **Abstract**

A contactor control circuit according to embodiments of the present disclosure includes a first inverting circuit that generates an inverted drive signal by inverting a drive signal received through a first input terminal, a second inverting circuit that generates an inverted abnormal signal by inverting the abnormal signal received through the second input terminal, a delay circuit that outputs a high-level reset signal for a preset delay time if the inverted abnormal signal transitions from low level to high level, a D-flip-flop that generates an output signal based on the driving signal, the inverted driving signal, the inverted abnormal signal, and the reset signal, and a logical sum circuit that generates a control signal by performing a logical sum operation on the driving signal and the output signal.

## Description

### FIELD

One or more embodiments relate to a contactor control circuit for a battery pack, and more specifically, to a contactor control circuit having a retention function.

### BACKGROUND

Secondary batteries may be charged and discharged unlike primary batteries which cannot be recharged. Small batteries are used in small, portable electronic devices, such as smartphones, feature phones, laptop computers, digital cameras, and camcorders, while large batteries are widely used in hybrid vehicles, electric vehicles, and energy storage systems.

A battery cell is a basic unit of a secondary battery and includes an electrode assembly consisting of an anode, a separator, and a cathode, electrode terminals respectively connected to the anode and the cathode, and a case for accommodating the electrode assembly and an electrolyte. A battery module is formed by combining a certain number of battery cells into one frame to increase battery output and protect against external shock, heat, and vibration. A battery pack is completed by connecting multiple number of battery modules and adding a battery management system for electrical control and thermal management. The battery management system includes a microcontrol unit (MCU), sensors, analog front end (AFE), protection elements, and other electronic circuits. The battery management system further includes a power management integrated circuit (PMIC) that supplies driving power to the MCU, AFE, etc. and outputs an abnormal signal if an abnormal state of the MCU is detected by checking the operation of the MCU.

However, a temporary communication failure between the MCU and the PMIC may occur due to an electrical shock such as a thunderstorm or a physical impact in an external environment, thus an abnormal signal is output. Because this does not mean that an error has actually occurred in the MCU, a protection operation should not be performed in immediate response to this error signal.

The described information disclosed in the background technology of the present disclosure is only for improving understanding of the background of the present disclosure, and therefore may include information that does not constitute prior art.

### SUMMARY

One or more embodiments include a contactor control circuit having a retention function so that a contactor may maintain its previous state for a predetermined period of time even if an abnormal signal is output and a battery pack including the same.

Additional aspects will be set forth in part in the description which follows and, in part, will be apparent from the description, or may be learned by practice of the presented embodiments of the present disclosure.

According to one or more embodiments, a contactor control circuit includes a first inverting circuit that inverts a driving signal to generate an inverted driving signal, a second inverting circuit that inverts an abnormal signal to generate an inverted abnormal signal, a delay circuit that outputs a high-level reset signal for a preset delay time if the inverted abnormal signal transitions from a low level to a high level, a D-flip-flop that generates an output signal based on the driving signal, the inverted driving signal, the inverted abnormal signal, and the reset signal, and a logical sum circuit that generates a control signal by performing a logical sum operation on the driving signal and the output signal. The abnormal signal may be generated when the contactor control circuit determines that an abnormal condition occurs, the abnormal condition may include at least one of overcharge, overdischarge, high temperature, and overcurrent.

According to one example, the delay circuit may include a first npn transistor controlled based on the inverted abnormal signal and the reset signal, a second npn transistor outputting the reset signal from the collector, a first capacitor between the collector of the first npn transistor and the base of the second npn transistor, and a first resistor between the collector of the second npn transistor and the base of the first npn transistor.

According to another example, the delay circuit may further include a second resistor between a voltage terminal to which a driving voltage is applied and the collector of the first npn transistor, a third resistor between the voltage terminal and the base of the second npn transistor, a fourth resistor between the voltage terminal and the collector of the second npn transistor, and a fifth resistor between an output terminal of the second inverting circuit that outputs the inverted abnormal signal and the base of the first npn transistor.

According to another example, the delay circuit may further include a sixth resistor between the base of the first npn transistor and a ground terminal. The ground terminal may be connected to an emitter of the first npn transistor and an emitter of the second npn transistor.

According to another example, the delay circuit may further include a seventh resistor between an output terminal of the second inverting circuit and a clock input terminal of the D flip-flop, and a second capacitor between the clock input terminal of the D-flip-flop and the ground terminal.

According to another example, the D-flip-flop may include a data input terminal for receiving the driving signal, a clock input terminal for receiving the inverted abnormal signal, an active-low set terminal for receiving the inverted driving signal, an active-low reset terminal for receiving the reset signal, and an output terminal for outputting the output signal.

According to one or more embodiments, a battery pack includes first and second pack terminals, a battery having at least one battery cell, a contactor connected between the battery and the first pack terminal, a microcontrol unit (MCU) that outputs a driving signal, a power management integrated circuit (PMIC) that monitors the status of the MCU and outputs an abnormal signal, and a contactor control circuit that receives the driving signal through a first input terminal, receives the abnormal signal through a second input terminal, and generates a control signal for controlling the contactor based on the driving signal and the abnormal signal. The contactor control circuit may include a first inverting circuit that generates an inverted driving signal by inverting the driving signal, a second inverting circuit that generates an inverted abnormal signal by inverting the abnormal signal, a delay circuit that outputs a high-level reset signal for a preset delay time if the inverted abnormal signal transitions from a low level to a high level, a D-flip-flop that generates an output signal based on the driving signal, the inverted driving signal, the inverted abnormal signal, and the reset signal, and a logical sum circuit that generates the control signal by performing a logical sum operation on the driving signal and the output signal.

According to one example, the MCU may output the driving signal at a high level to short-circuit the contactor and output the driving signal at a low level to disconnect the contactor. The PMIC may output the abnormal signal at a high level if the MCU is in a normal state and outputs the abnormal signal at a low level if the MCU is monitored in an abnormal state.

According to another example, the delay circuit may include a first npn transistor controlled based on the inverted abnormal signal and the reset signal, a second npn transistor outputting the reset signal from the collector, a first capacitor between the collector of the first npn transistor and the base of the second npn transistor, and a first resistor between the collector of the second npn transistor and the base of the first npn transistor.

According to another example, the delay circuit may further include a second resistor between a voltage terminal to which a driving voltage is applied and the collector of the first npn transistor, a third resistor between the voltage terminal and the base of the second npn transistor, a fourth resistor between the voltage terminal and the collector of the second npn transistor, and a fifth resistor between an output terminal of the second inverting circuit that outputs the inverted abnormal signal and the base of the first npn transistor.

According to another example, the delay circuit may further include a sixth resistor between the base of the first npn transistor and a ground terminal. The ground terminal may be connected to an emitter of the first npn transistor and an emitter of the second npn transistor.

According to another example, the delay circuit may further include a seventh resistor between an output terminal of the second inverting circuit and a clock input terminal of the D flip-flop and a second capacitor between the clock input terminal of the D-flip-flop and the ground terminal.

According to another example, the D-flip-flop may include a data input terminal for receiving the driving signal, a clock input terminal for receiving the inverted abnormal signal, an active-low set terminal for receiving the inverted driving signal, an active-low reset terminal for receiving the reset signal, and an output terminal for outputting the output signal.

According to one or more embodiments, a contactor control circuit includes a first input terminal for receiving a driving signal, a second input terminal for receiving an abnormal signal, a first inverting circuit that generates an inverted abnormal signal by inverting the abnormal signal, a delay circuit that outputs a high-level reset signal for a preset delay time if the inverted abnormal signal transitions from a low level to a high level, a second inverting circuit that generates an inverted reset signal by inverting the reset signal, a D-flip-flop that generates an output signal based on the driving signal, the inverted abnormal signal, and the inverted reset signal, and a logical sum circuit that generates a control signal by performing a logical sum operation on the driving signal and the output signal.

According to one example, the D-flip-flop may include a data input terminal for receiving the driving signal, a clock input terminal for receiving the inverted abnormal signal, an active-high set terminal for receiving the driving signal, an active-high reset terminal for receiving the inverted reset signal, and an output terminal for outputting the output signal.
According to one or more embodiments, a battery pack includes first and second pack terminals, a battery having at least one battery cell, a contactor connected between the battery and the first pack terminal, a microcontrol unit (MCU) that outputs a driving signal, a power management integrated circuit (PMIC) that monitors the status of the MCU and outputs an abnormal signal, and a contactor control circuit as described above.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a schematic diagram showing a battery pack according to embodiments of the present disclosure;
FIG. 2 is a block diagram of a contactor control circuit according to embodiments of the present disclosure;
FIG. 3 shows a circuit diagram of a contactor control circuit according to embodiments of the present disclosure;
FIGS. 4A and 4B show signal waveform diagrams of the contactor control circuit of FIG. 3; and
FIG. 5 shows a circuit diagram of a contactor control circuit according to another embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Now, embodiments will be described in more detail with reference to the accompanying drawings. However, the present disclosure may be embodied in many different forms and should not be considered limited to the embodiments described herein. Rather, these embodiments are provided so that this disclosure will be thorough and complete, and will fully convey the scope of the invention to one of ordinary skill in the art.

Terms used in the present specification are only used to describe a specific embodiment and are not intended to limit various embodiments of the present disclosure. The singular forms include the plural forms unless the context clearly indicates otherwise. In the present application, terms such as "include" or "have" are intended to designate that there are features, numbers, steps, operations, components, parts, or combinations thereof described in the specification, but it should be understood that it does not preclude the possibility of the presence or addition of one or more other features, numbers, steps, operations, components, parts, or combinations thereof. Although first, second, etc. are used to describe various components, these components are of course not limited by these terms. These terms are only used to distinguish one component from another component.

Hereinafter, embodiments will now be more completely described with reference to the accompanying drawings, in which embodiments are shown. Like reference numbers refer to the like elements throughout. In the drawings, like reference numbers are given to identical or corresponding components and description thereof will not be repeated.

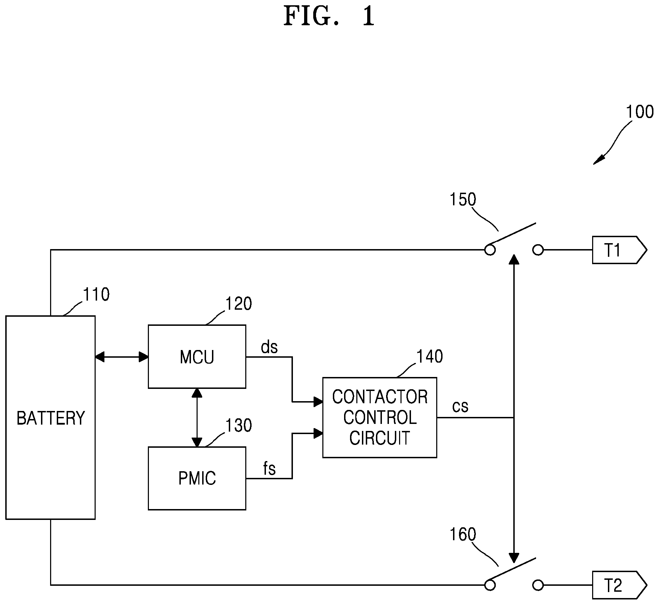

FIG. 1 is a schematic diagram showing a battery pack 100 according to embodiments of the present disclosure.

Referring to FIG. 1, the battery pack 100 may include a battery 110 connected between first and second pack terminals T1 and T2, a microcontrol unit (MCU) 120, a power management integrated circuit (PMIC) 130, and a contactor control circuit 140, a first contactor 150, and a second contactor 160.

The battery 110 may include at least one battery cell. The battery 110 may include a plurality of battery modules electrically connected to each other. Each of the battery modules may include a plurality of battery cells.

A battery cell may be a part that stores power and may be a rechargeable secondary battery. For example, the battery cells may include at least one selected from the group consisting of lithium ion batteries, lithium polymer batteries, nickel cadmium batteries, nickel metal hydride (Ni-MH) batteries, nickel zinc (Ni-Zn) batteries, and lead acid batteries, etc.

The total number and connection configuration of battery cells included in the battery 110 may be determined according to an output voltage and power storage capacity required for the battery pack 100.

The battery 110 may be connected to the first pack terminal T1 through the first contactor 150 and to the second pack terminal T2 through the second contactor 160. The first contactor 150 and the second contactor 160 may be, for example, magnetic contactors or relay switches. The first contactor 150 and the second contactor 160 may be commonly shorted (i.e., turn on) or open (i.e., turn off) based on a control signal cs output from the contactor control circuit 140. FIG. 1 shows the first contactor 150 and the second contactor 160 respectively connected to positive and negative electrodes of the battery 110, but one of the first contactor 150 and the second contactor 160 may be omitted.

The battery pack 100 may include a battery management system. The battery management system for managing the battery pack 100 may include the MCU 120 configured to perform an overall management and a protection operation of the battery pack 100, the PMIC 130 configured to supply necessary driving power to the MCU 120 and to monitor the status of the MCU 120, and the contactor control circuit 140 configured to control the first and second contactors 150 and 160. In addition to the MCU 120, PMIC 130, and contactor control circuit 140, the battery management system may further include sensing elements, such as an analog front end (AFE), a current sensor, and a temperature sensor, and a contactor driving circuit that directly controls the first and second contactors 150 and 160.

The AFE may monitor a cell voltage of the battery cells included in the battery 110. The AFE may monitor a temperature of the battery 110 using a temperature sensor. The AFE may monitor a charging and discharging current of the battery 110 using a current sensor. The battery management system may include a cell balancing circuit for equalizing cell voltages of the battery cells included in the battery 110. The AFE may control the cell balancing circuit. The AFE may provide monitored data to the MCU 120 and perform operations under the control of the MCU 120.

The MCU 120 may collect status information of the battery 110 provided from the AFE, and based on the status information, may manage an overall operation of the battery pack 100 and perform operations to protect the battery 110. For example, the MCU 120 may determine whether an abnormal condition such as overcharge, overdischarge, high temperature, or overcurrent occurs or not by comparing battery data with a preset reference value.

If the MCU 120 determines that the battery 110 is in a normal state, the MCU 120 may output a driving signal ds of a first voltage level to charge or discharge the battery 110. If the MCU 120 determines that an abnormal state has occurred, it may output a driving signal ds at a second voltage level to disconnect the battery 110. The first voltage level may be a high level and the second voltage level may be a low level. For example, the first voltage level may be +1V, and the second voltage level may be 0V or ground voltage.

The PMIC 130 may provide driving power for driving a circuit, such as the MCU 120 and electrical devices in the battery management system. The PMIC 130 may monitor the status of the MCU 120. For example, if the PMIC 130 determines that the MCU 120 is in an abnormal state, the PMIC 130 may temporarily block a driving voltage supplied to the MCU 120 or provide a reset voltage to reset or reboot the MCU 120. To this end, the PMIC 130 may communicate with the MCU 120 at a preset period or exchange pulses. For example, if communication with the MCU 120 is lost or pulses are not received for a preset time, the PMIC 130 may determine that an error has occurred in the MCU 120.

The PMIC 130 may output an abnormal signal fs indicating the state of the MCU 120. For example, if the PMIC 130 determines that the MCU 120 is in a normal state, the PMIC 130 may output an abnormal signal fs of a first voltage level, and if the PMIC 130 determines that the MCU 120 is in an abnormal state, the PMIC 130 may output an abnormal signal fs of a second voltage level. For example, the first voltage level may be +3.3V, and the second voltage level may be 0V or ground voltage. The status of the PMIC 130 may be monitored by the MCU 120.

The contactor control circuit 140 may receive a driving signal ds from the MCU 120, receive an abnormal signal fs from the PMIC 130, and may generate a control signal cs for controlling the first and second contactors 150 and 160 based on the driving signal ds and the abnormal signal fs. The contactor control circuit 14 may have a first input terminal for receiving the driving signal ds, a second input terminal for receiving the abnormal signal fs, and an output terminal for outputting the control signal cs.

For example, if the driving signal ds is at a high level, the contactor control circuit 140 may output a high level control signal cs. If a low-level abnormal signal fs is temporarily received in the contactor control circuit 140, even if a low-level driving signal ds is received later, the contactor control circuit 140 may output a high-level control signal cs for a preset holding time. In this respect, the contactor control circuit 140 may be referred to as a retention circuit having a retention function.

The first and second contactors 150 and 160 may be short-circuited based on the high-level control signal cs and opened based on the low-level control signal cs. The high-level control signal cs may be, for example, 1V, and the low-level control signal cs may be, for example, 0V or ground voltage.

Although not shown in FIG. 1, the battery pack 100 may further include a contactor driving circuit that outputs a contactor driving voltage in response to a high-level control signal cs. The contactor driving circuit may include a driving switch connected between an input terminal to which a contactor driving voltage is applied and the control terminal of the first and second contactors 150 and 160 and controlled by the control signal cs. The driving switch may be, for example, a metaloxide semiconductor field effect transistor (MOSFET) or a relay switch, and may be turned on in response to a high-level control signal cs and turned off in response to a low-level control signal cs.

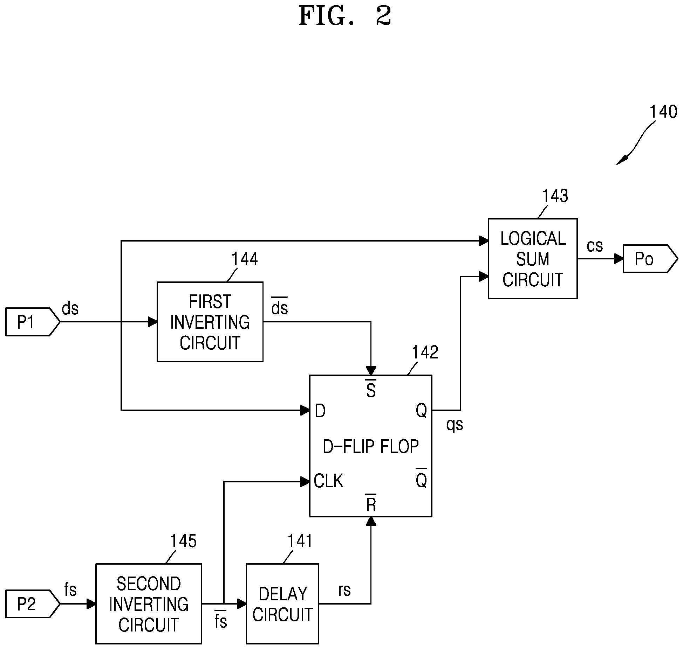

The contactor control circuit 140 is described in more detail below with reference to FIGS. 2 to 5.

2 shows a circuit diagram of a contactor control circuit according to embodiments of the present invention.

Referring to FIG. 2 together with FIG. 1, the contactor control circuit 140 may include a delay circuit 141, a D-flip-flop 142, a logical sum circuit 143, a first inverting circuit 144, and a second inverting circuit 145. The contactor control circuit 140 may further include a first input terminal P1, a second input terminal P2, and an output terminal Po.

The first inverting circuit 144 may invert the driving signal ds to generate an inverted driving signal ds. The second inverting circuit 145 may invert the abnormal signal fs to generate an inverted abnormal signal *f̅s̅.* If the inverted abnormal signal *f̅s̅* is transited from a low level to high level, the delay circuit 141 may output a high-level reset signal rs for a preset delay time. The D-flip-flop 142 may generate an output signal qs based on the driving signal ds, the inverted driving signal *d̅s̅*, the inverted abnormal signal *f̅s̅,* and the reset signal rs. The logical sum circuit 143 may generate a control signal cs by performing a logical sum operation on the driving signal ds and the output signal qs.

The driving signal ds output by the MCU 120 is input to the first input terminal P1. The MCU 120 may output a driving signal ds to control the first and second contactors 150 and 160. The first and second contactors 150 and 160 may be short-circuited (i.e., turned on) in response to the high-level driving signal ds, and may be opened (i.e., turned off) in response to the low-level driving signal ds. The driving signal ds is input to the D-flip-flop 142, a logical sum circuit OR, and the first inverting circuit INV1. The high-level driving signal ds may be 1V, and the low-level driving signal ds may be 0V.

The abnormal signal fs outputted by the PMIC 130 is input to the second input terminal P2. The PMIC 130 that monitors the state of the MCU 120 may output an abnormal signal fs indicating the state of the MCU 120. The abnormal signal ds may be at a high-level if the MCU 120 is in a normal state and may be at a low-level if the MCU 120 is in an abnormal state. The abnormal signal fs is input to a second inverting circuit INV2. The high-level abnormal signal fs may be 3.3V, and the low-level abnormal signal fs may be 0V.

The first inverting circuit 144 may receive the driving signal ds through the first input terminal P1 and invert the driving signal ds to generate an inverted driving signal *d̅s̅*. The first inverting circuit 144 may be a logical NOT gate. The second inverting circuit 145 may receive the abnormal signal fs through the second input terminal P2 and invert the abnormal signal fs to generate an inverted abnormal signal *f̅s̅.* The second inverting circuit 145 may be a logical NOT gate.

The delay circuit 141 may receive the inverted abnormal signal *f̅s̅* from the second inverting circuit 145, and if the inverted abnormal signal *f̅s̅* transitions from low-level to high-level, may output a high-level reset signal rs for a preset delay time. Even if the inverted abnormal signal *f̅s̅* falls to a low-level immediately after the transition from a low-level to a high-level, the delay circuit 141 may output a high-level reset signal rs for a preset delay time from a rising edge of the inverted abnormal signal *f̅s̅.* If the inverted abnormal signal *f̅s̅* is at a low level, the delay circuit 141 may output a low-level reset signal rs.

The D-flip-flop 142 may receive a driving signal ds, an inverted driving signal *d̅s̅*, an inverted abnormal signal *f̅s̅,* and a reset signal rs, and generate an output signal qs by performing a D-flip-flop operation on the driving signal ds, the inverted driving signal *d̅s̅*, the inverted abnormal signal *f̅s̅,* and the reset signal rs. The D-flip-flop 142 may be a D-flip-flop having active low set and reset functions. The driving signal ds may be input to a data input terminal D of the D-flip-flop 142, the inverted abnormal signal *f̅s̅* may be input to a clock input terminal CLK, the inverted driving signal *d̅s̅* may be input to an active-low set terminal *S̅*, and the reset signal rs may be input to the active-low reset terminal *R̅*.

If a low-level inverted driving signal *d̅s̅* is input to the active-low set terminal *S̅* and a high-level reset signal rs is input to the active-low reset terminal β, the D-flip-flop 142 may output a high-level output signal qs through an output terminal Q. Conversely, if the high-level inverted drive signal *d̅s̅* is input to the active-low set terminal *S̅* and the low-level reset signal rs is input to the active-low reset terminal β, the D-flip-flop 142 may output a low-level output signal qs.

If the high-level inverted drive signal *d̅s̅* and the high-level reset signal rs are input to the active-low set terminal *S̅* and the active-low reset terminal *R̅*, respectively, the D-flip-flop 142 may perform a D-flip-flop operation. The D-flip-flop 142 may output an output signal qs at the same level as the logic level of the driving signal ds at the point if the inverted abnormal signal *f̅s̅* input to the clock input terminal CLK has a rising edge. If both the inverted driving signal *d̅s̅* and the reset signal rs are at a low-level, the D-flip-flop 142 may output an output signal qs at the same level as before regardless of the logic levels of the inverted abnormal signal *f̅s̅* and the driving signal ds.

The logical sum circuit 143 may receive a driving signal ds and an output signal qs from the MCU 120 and the D-flip-flop 142, respectively, and generate a control signal cs by performing logic sum operation on the driving signal ds and the output signal qs. The control signal cs is output through the output terminal Po and is used to control the first and second contactors 150 and 160.

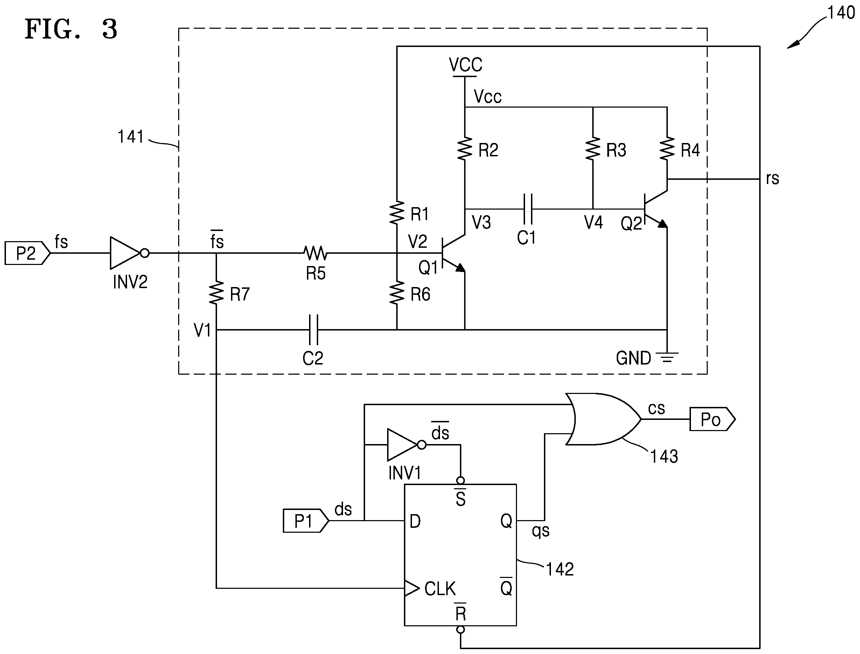

FIG. 3 shows a circuit diagram of a contactor control circuit 140 according to embodiments of the present disclosure.

Referring to FIG. 3 together with FIG. 1, the contactor control circuit 140 may further include a first input terminal P1, a second input terminal P2, and an output terminal Po. The driving signal ds output by the MCU 120 is input to the first input terminal P1, and the abnormal signal fs output by the PMIC 130 is input to the second input terminal P2. The output signal cs is output through the output terminal Po.

The contactor control circuit 140 includes a delay circuit 141, a D-flip-flop 142, a logical sum circuit OR, a first inverting circuit INV1, and a second inverting circuit INV2. The driving signal ds received through the first input terminal P1 may be inverted in the first inverting circuit INV1 to generate an inverted driving signal *d̅s̅*. The driving signal ds is input to the data input terminal D of the D-flip-flop 142 and the input terminal of the logical sum circuit OR. The abnormal signal fs received through the second input terminal P2 is inverted in the second inverting circuit INV2 to generate the inverted abnormal signal *f̅s̅.* The inverted abnormal signal *fs* is input to the clock input terminal CLK of the D-flip-flop 142 and the delay circuit 141.

The delay circuit 141 may receive the inverted abnormal signal *f̅s̅* from the second inverting circuit INV2, and if the inverted abnormal signal *f̅s̅* transitions from low-level to high-level, may outputs\ a high-level reset signal rs for a preset delay time.

The delay circuit 141 may include a first npn transistor Q1 controlled based on the inverted abnormal signal *f̅s̅* and the reset signal rs, and a second npn transistor Q2 that outputs a reset signal rs from a collector, a first capacitor C1 between the collector of the first npn transistor Q1 and a base of the second npn transistor Q2, and a first resistor R1 between the collector of the second npn transistor Q2 and the base of the first npn transistor Q1. The first npn transistor Q1 is turned on if a base voltage V2 is higher than a threshold voltage. The first npn transistor Q1 is turned on if either the inverted abnormal signal *f̅s̅* or the reset signal rs is at a high-level. If the first npn transistor Q1 is turned on, the collector is connected to a ground terminal GND, and a collector voltage V3 drops from a driving voltage Vcc to the ground voltage (ie, 0V). A base voltage V4 of the second npn transistor Q2 may also drop below the threshold voltage by the first capacitor C1, and the second npn transistor Q2 is turned off. At this time, a high-level reset signal rs is output from the collector of the second npn transistor Q2. The first capacitor C1 is charged as time passes and a level of the base voltage V4 increases, the second npn transistor Q2 is turned on and a low-level reset signal rs is output.

The delay circuit 141 may further include a second resistor R2 between a voltage terminal VCC to which the driving voltage Vcc is applied and the collector of the first npn transistor Q1, a third resistor R3 between the voltage terminal VCC and the base of the second npn transistor Q2, a fourth resistor R4 between the voltage terminal VCC and the collector of the second npn transistor Q2, and a fifth resistor R5 between the output terminal of the second inverting circuit INV2 outputting the inverted abnormal signal *f̅s̅* and the base of the first npn transistor Q1. If the first npn transistor Q1 is turned off, the driving voltage Vcc is applied to the first electrode of the first capacitor C1 by the second resistor R2, and the level of the collector voltage V3 may be substantially the same as the driving voltage Vcc. The driving voltage Vcc is applied to the second electrode of the first capacitor C1 through the third resistor R3. The first capacitor C1 is charged by a current flowing through the third resistor R3, and a resistance value of the third resistor R3 and a capacitance of the first capacitor C1 may determine a rate of increasing the base voltage of the second npn transistor R3. As the larger the resistance value of the third resistor R3, and the larger the capacitance of the first capacitor C1, the longer the delay time is set. If the second npn transistor Q2 is turned on by the fourth resistor R4, a low-level reset signal rs is output.

The delay circuit 141 may further include a sixth resistor between the base of the first npn transistor Q1 and the ground terminal GND. The ground terminal GND may be connected to an emitter of the first npn transistor Q1 and an emitter of the second npn transistor Q2.

The delay circuit 141 may further include a seventh resistor R7 between the output terminal of the second inverting circuit INV2 and the clock input terminal CLK of the D-flip-flop 142, and a second capacitor C2 between the clock input terminal CLK and the ground terminal GND of the D-flip-flop 142. A node between the seventh resistor R7 and the second capacitor C2 is connected to the clock input terminal CLK of the D-flip-flop 142, and a signal input to the clock input terminal CLK of the D-flip-flop 142 is expressed as a clock voltage V1.

The D-flip-flop 142 may perform a D-flip-flop operation on the driving signal ds, the inverted driving signal *d̅s̅* the inverted abnormal signal *f̅s̅,* and the reset signal rs to generates an output signal qs. A driving signal ds is input to the data input terminal D of the D-flip-flop 142, an inverted abnormal signal *f̅s̅* is input to the clock input terminal CLK, an inverted driving signal *d̅s̅* is input to the active-low set terminal *S̅*, and a reset signal rs is input to the active-low reset terminal *R̅*.

The logical sum circuit OR may generate a control signal cs by performing a logical sum operation on the driving signal ds and the output signal qs. The control signal cs may be output through the output terminal Po.

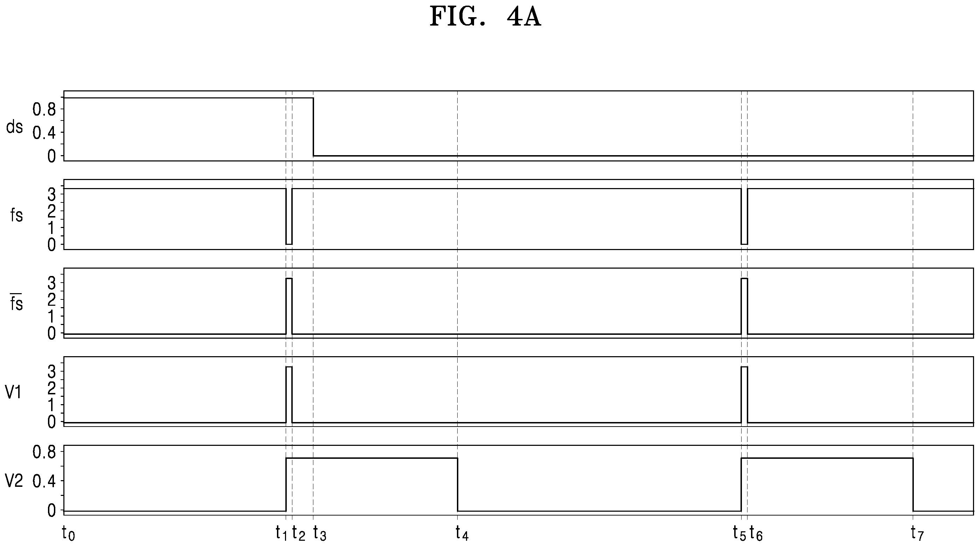

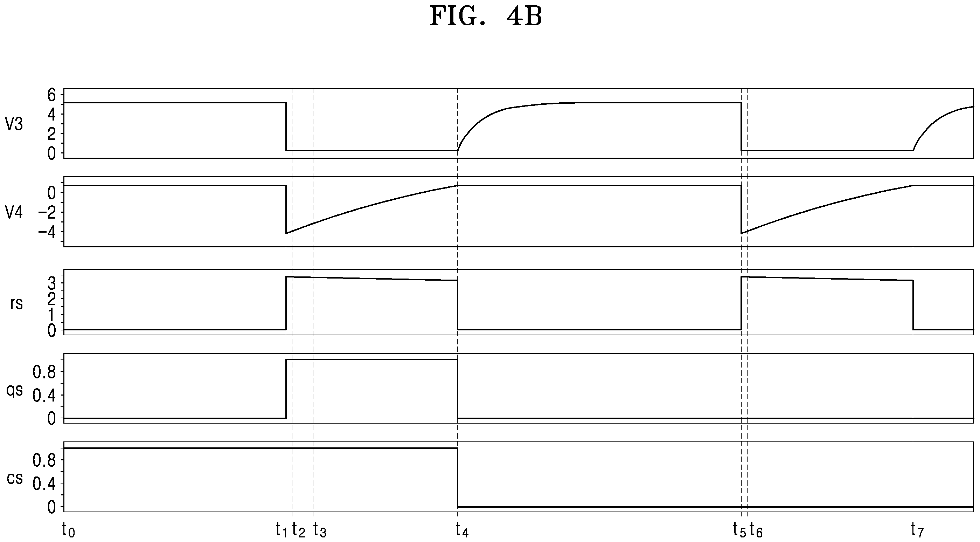

FIGS. 4A and 4B are diagrams showing signal waveforms of the contactor control circuit 140 of FIG. 3.

Referring to FIGS. 4A and 4B together with FIGS. 1 and 3, at a initial time t₀, the first and second contactors 150 and 160 are turned on according to the high-level driving signal ds, and the abnormal signal fs is a high-level indicating that the MCU 120 is in a normal state. For example, the high-level driving signal ds is 1V, and the high-level abnormal signal fs is 3.3V. Both the inverted drive signal *d̅s̅* and the inverted abnormal signal *f̅s̅* are at a low level by the first and second inverting circuits INV1 and INV2. The first npn transistor Q1 is turned off according to the low-level inverted abnormal signal *f̅s̅,* and the collector voltage V3 of the first npn transistor Q1 is equal to the driving voltage Vcc. The driving voltage Vcc may be, for example, 5V. The base voltage V4 of the second npn transistor Q2 becomes a turn-on voltage (e.g., 0.7V) for turning on the second npn transistor Q2. Because the second npn transistor Q2 is turned on, the reset signal rs has a low level. The low-level inverted driving signal *d̅s̅* is input to the active-low set terminal *S̅* of the D-flip-flop 142, and the low-level reset signal rs is input to the active-low reset terminal *R̅*. At this time, the D-flip-flop 142 outputs a low-level output signal qs. Because the driving signal ds is at a high level, the logical sum circuit OR outputs a high-level control signal cs.

It is assumed that the PMIC 130 detects an abnormality in the MCU 120 at a first time point t₁ and thus outputs a low-level abnormal signal fs. If the abnormal signal fs transitions from a high level to a low level, the inverted abnormal signal *f̅s̅* transitions from a low level to a high level. A clock signal V1 also transitions from a low level to a high level, and thus, has a rising edge. As the high-level inverted abnormal signal *f̅s̅* is applied to the base of the first npn transistor Q1, the first npn transistor Q1 is turned on, and the base voltage V2 becomes a turn-on voltage. The collector voltage V3 of the first npn transistor Q1 drops from the driving voltage Vcc to the ground voltage (that is, 0 V). The base voltage V4 of the second npn transistor Q2 also decreases by -Vcc from the turn-on voltage due to the first capacitor C1. The base voltage V4 is decreased to -4.3 V. The second npn transistor Q2 is turned off, the reset voltage rs becomes a high level, and the high-level reset voltage rs is input to the base of the first npn transistor Q1 and the active low reset terminal *R̅* of the D-flip-flop 142. In the D-flip-flop 142, a low-level inverted driving signal *d̅s̅* is input to the active-low set terminal *S̅* and a high-level reset signal rs is input to the active-low reset terminal *R̅*, the D-flip-flop 142 outputs a high-level output signal qs. The logical sum circuit OR outputs a high-level control signal cs based on the high-level driving signal ds and the high-level output signal qs.

It is assumed that a temporary abnormality has occurred in the MCU 12. At a second time point t₂, the PMIC 130 outputs a high-level abnormal signal fs. The inverted abnormal signal *f̅s̅* transitions to a low level. However, because a high-level reset signal rs is applied to the base of the first npn transistor Q1, the first npn transistor Q1 remains a turned-on state. Because a current by the driving voltage Vcc flows to the base of the second npn transistor Q2 through the third resistor R3, the base voltage V4 may gradually increase as the first capacitor C1 is charged. However, because the base voltage V4 is lower than the threshold voltage of the second npn transistor Q2, the second npn transistor Q2 is turned off, and the reset signal rs still has a high level. A low-level clock voltage V1 is applied to the clock input terminal CLK of the D-flip-flop 142, but a low-level inverted driving signal *d̅s̅* is input to the active low set terminal *S̅* and a high-level reset signal rs is input to the active-low reset terminal *R̅*, the D-flip-flop 142 still outputs the high-level output signal qs. The logical sum circuit OR outputs a high-level control signal cs based on the high-level driving signal ds and the high-level output signal qs.

It is assumed that the MCU 120 outputs a low-level driving signal ds at a third time point t₃. The inverted drive signal *d̅s̅* becomes a high level. Because the high-level inverted driving signal *d̅s̅* is input to the active-low set terminal *S̅* and the high-level reset signal rs is input to the active-low reset terminal *R̅*, the D-flip-flop 142 may output a high-level output signal qs as before. The logical sum circuit OR outputs a high-level control signal cs according to the high-level output signal qs despite the low-level driving signal ds.

At a fourth time point t₄ at which the base voltage V4 of the second npn transistor Q2 gradually increases and reaches the threshold voltage of the second npn transistor Q2, the second npn transistor Q2 is turned on and the reset signal rs has a low level. Because the high-level inverted driving signal *d̅s̅* is input to the active-low set terminal *S̅* and the low-level reset signal rs is input to the active-low reset terminal *R̅*, the D-flip-flop 142 may be in a reset state and output a low-level output signal qs. Because a low-level driving signal ds and a low-level output signal qs are input to the logical sum circuit OR, a low-level control signal cs is output. In this regard, the first and second contactors 150 and 160 may be turned off at the fourth time point t₄ in response to the low-level control signal cs. Because the low-level reset signal rs and the low-level inverted abnormal signal *f̅s̅* are input to the base of the first npn transistor Q1, the first npn transistor Q1 is turned off, and the collector voltage V3 of the collector connected to the first capacitor C1 gradually increases.

It is assumed that, in a state that the MCU 120 outputs a low-level driving signal ds, the PMIC 130 detects an abnormality in the MCU 120 at a fifth time point t₅ and outputs a low-level abnormal signal fs. If the low-level abnormal signal fs transitions from a high level to a low level, the inverted abnormal signal *f̅s̅* transitions from a low level to a high level. The clock signal V1 also transitions from low level to high level, and thus, has a rising edge. As the high-level inverted abnormal signal *f̅s̅* is applied to the base of the first npn transistor Q1, the first npn transistor Q1 is turned on, and the base voltage V2 becomes a turn-on voltage. The collector voltage V3 of the first npn transistor Q1 drops from the driving voltage Vcc to the ground voltage (that is, 0 V). The base voltage V4 of the second npn transistor Q2 also decreases by -Vcc from the turn-on voltage by the first capacitor C1. The second npn transistor Q2 is turned off, the reset voltage rs becomes a high level, and the high-level reset voltage rs is input to the base of the first npn transistor Q1 and the active low rset terminal *R̅* of the D-flip-flop 142. Because a high-level inverted driving signal *d̅s̅* is input to the active low set terminal *S̅* of the D-flip-flop 142, and a high-level reset signal rs is input to the active low reset terminal *R̅*, the D-flip-flop 142 is in a state capable of performing a D-flip-flop operation. However, because the high-level reset signal rs is input to the active-low reset terminal *R̅* after the clock signal V1 has a rising edge, the D-flip-flop 142 outputs a low-level output signal qs as before. Because the logical sum circuit OR receives a low-level driving signal ds and a low-level output signal qs, and thus, the logical sum circuit OR outputs a low-level control signal cs.

At a sixth time t₆, the PMIC 130 determines that the MCU 120 has a temporary abnormality and outputs a high-level abnormality signal fs. The inverted abnormal signal *f̅s̅* transitions to a low level. However, because a high-level reset signal rs is applied to the base of the first npn transistor Q1, the first npn transistor Q1 remains in a turned-on state. Because a current by the driving voltage Vcc flows to the base of the second npn transistor Q2 through the third resistor R3, the base voltage V4 gradually increases as the first capacitor C1 is charged. However, the second npn transistor Q2 remains in a turned-off state, and the reset signal rs still has a high level. Because a high-level inverted driving signal *d̅s̅* is input to the active-low set terminal *S̅* and a high-level reset signal rs is input to the active-low reset terminal *R̅*, the D-flip-flop 142 still outputs a low-level output signal qs. The logical sum circuit OR outputs a low-level control signal cs based on the low-level driving signal ds and the low-level output signal qs.

At a seventh time point t₇ at which the base voltage V4 of the second npn transistor Q2 gradually increases and reaches the threshold voltage of the second npn transistor Q2, the second npn transistor Q2 is turned on and the reset signal rs has a low level. Because a high-level inverting drive signal *d̅s̅* is input to the active-low set terminal *S̅* and a low-level reset signal rs is input to the active-low reset terminal *R̅*, the D-flip-flop 142 is in a reset state and outputs a low-level output signal qs. Because a low-level driving signal ds and a low-level output signal qs are input to the logical sum circuit OR, a low-level control signal cs is output. Because a low-level reset signal rs and a low-level inverted abnormal signal *f̅s̅* are input to the base of the first npn transistor Q1, the first npn transistor Q1 is turned off, and the collector voltage V3 of the first npn transistor Q1 is gradually increased.

As described above, if the driving signal ds is at a high-level, the contactor control circuit 140 outputs a high-level control signal cs. If the low-level abnormal signal fs is temporarily received in the contactor control circuit 140, even if a low-level driving signal ds is received later, the contactor control circuit 140 may output a high-level control signal cs for a preset holding time. In this regard, the first and second contactors 150 and 160 may not be immediately turned off due to the temporary abnormal signal fs.

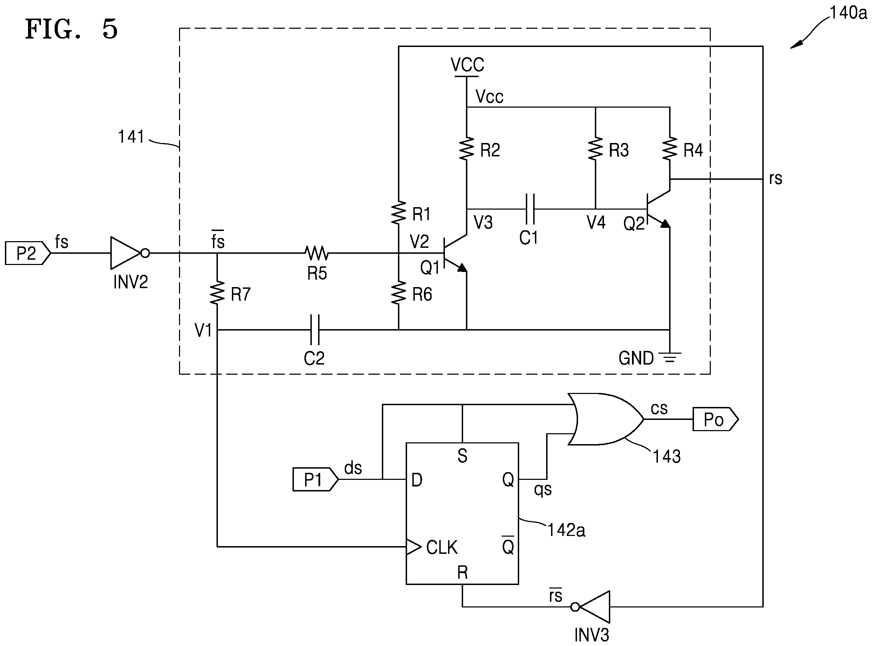

FIG. 5 shows a circuit diagram of a contactor control circuit 140a according to another embodiment.

Referring to FIG. 5 together with FIG. 1, the contactor control circuit 140a may further include a first input terminal P1, a second input terminal P2, and an output terminal Po. A driving signal ds output by the MCU 120 is input to the first input terminal P1, and an abnormal signal fs output by a PMIC 130 is input to the second input terminal P2. An output signal cs is output through the output terminal Po.

The contactor control circuit 140a may include a delay circuit 141, a D-flip-flop 142a, a logical sum circuit OR, a second inverting circuit INV2, and a third inverting circuit INV3. The driving signal ds received through the first input terminal P1 is input to a data input terminal D and the active high set terminal S of the D-flip-flop 142a and an input terminal of the logical sum circuit OR. The abnormal signal fs received through the second input terminal P2 is inverted in the second inverting circuit INV2 to generate an inverted abnormal signal *f̅s̅.* The inverted abnormal signal *f̅s̅* is input to a clock input terminal CLK of the D-flip-flop 142a and the delay circuit 141.

The delay circuit 141 may receive the inverted abnormal signal *f̅s̅* from the second inverting circuit INV2, and if the inverted abnormal signal *f̅s̅* transitions from a low level to a high level, the delay circuit 141 outputs a high-level reset signal rs for a preset delay time. Because the delay circuit 141 was previously described with reference to FIG. 3, the description thereof will be omitted.

The reset signal rs is input to the third inverting circuit INV3. The third inverting circuit INV3 inverts the reset signal rs to generate an inverted reset signal *r̅s̅*. The inverted reset signal *r̅s̅* is input to an active high reset terminal R of the D-flip-flop 142a.

The D-flip-flop 142a may perform a D-flip-flop operation on the driving signal ds, the inverted abnormal signal *f̅s̅,* and the inverted reset signal *r̅s̅* to generate an output signal qs. The D-flip-flop 142a may be a D-flip-flop having active high set and reset functions. The driving signal ds is input to the data input terminal D and the active high set terminal S of the D-flip-flop 142a, and the inverted abnormal signal *f̅s̅* is input to the clock input terminal CLK and the inverted reset signal *r̅s̅* is input to the active high reset terminal R.

If the high-level driving signal ds is input to the active high set terminal S and the low-level inverted reset signal *r̅s̅* is input to the active high reset terminal R, the D-flip-flop 142a may output a high-level output signal qs through an output terminal Q. Conversely, if the low-level driving signal ds is input to the active high set terminal S and the high-level inverted reset signal *r̅s̅* is input to the active high reset terminal R, the D-flip-flop 142a may output a low level output signal qs.

If the low-level driving signal ds and the low-level inverted reset signal *r̅s̅* respectively are input to the active high set terminal S and the active high reset terminal R, the D-flip-flop 142a may perform a D-flip-flop operation. That is, the D-flip-flop 142a may output an output signal qs at the same level as the logic level of the driving signal ds at the point if the inverted abnormal signal *f̅s̅* inputted to the clock input terminal CLK has a rising edge. If both the driving signal ds and the inverted reset signal *r̅s̅* are at high levels, the D-flip-flop 142a may output the output signal qs at the same level as before.

The logical sum circuit 143 may receive a driving signal ds and an output signal qs respectively from the MCU 120 and the D-flip-flop 142a and generate a control signal cs by performing a logical sum operation on the driving signal ds and the output signal qs. The control signal cs is output through the output terminal Po and is used to control the first and second contactors 150 and 160.

According to the present disclosure, manufacturing costs may be reduced by simply implementing a contactor control circuit with a retention function using a switch transistor, a capacitor, a D-flip-flop, and an OR circuit. Also, elements, such as timer ICs that may cause malfunctions are not used, and thus, reliability may be improved.

Specific executions described in the present disclosure are example embodiments and do not limit the technical scope of the present invention even in any method For conciseness of the specification, disclosure of conventional electronic configurations, control systems, software, and other functional aspects of the systems may be omitted. In addition, connections or connection members of lines between components shown in the drawings illustrate functional connections and/or physical or circuit connections, and the connections or connection members may be represented by replaceable or additional various functional connections, physical connections, or circuit connections in an actual apparatus. Also, unless specifically stated as "essential," "important," etc., it is not considered an essential component.

In describing the embodiments (e.g., the patent claims), the use of the term "above" and similar directional terms may be applied to both singular and plural. Also, if the term "range" is described in the embodiments, it includes an individual value belonging to the range (unless otherwise described), and in the detailed description, it is equal to describe an individual value that constitutes the "range". Finally, with respect to operations that constitute a method, the operations may be performed in any appropriate sequence unless the sequence of operations is clearly described or unless the context clearly indicates otherwise. The operations may not necessarily be performed in the order of sequence. All examples or example terms (for example, etc.) are simply used to explain in detail the technical scope of the inventive concept, and thus, the scope of the inventive concept is not limited by the examples or the example terms as long as it is not defined by the claims. Also, it should be understood by those of ordinary skill in the art that the present disclosure is configured according to the design conditions and facts within the claims to which various modifications, combination, and revisions may be added or within a scope of an equivalent product.

Example embodiments are disclosed herein, and although specific terminology is used, such terminology is not intended to be limiting but should be construed as general and descriptive. In some examples, as will be apparent to those skilled in the art at the time of filing this application, features and/or components may be used alone or in combination with features and/or components described in connection with other embodiments, unless specifically stated otherwise. Therefore, the present disclosure should not be limited to the above-described embodiments, and not only the scope of the patent claims described below, but also all scopes equivalent to or equivalently changed from the scope of this patent claim, will be said to fall within the scope of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. A contactor control circuit (140) comprising:
a first inverting circuit (144) that inverts a driving signal to generate an inverted driving signal;
a second inverting circuit (145) that inverts an abnormal signal to generate an inverted abnormal signal;
a delay circuit (141) that outputs a high level reset signal for a preset delay time if the inverted abnormal signal transitions from a low level to a high level;
a D-flip-flop (142) that generates an output signal based on the driving signal, the inverted driving signal, the inverted abnormal signal, and the high level reset signal; and
a logical sum circuit (143) that generates a control signal by performing a logical sum operation on the driving signal and the output signal.

2. The contactor control circuit (140) as claimed in claim 1, wherein the delay circuit (141) includes:
a first npn transistor controlled based on the inverted abnormal signal and the reset signal;
a second npn transistor outputting the reset signal from the collector;
a first capacitor between the collector of the first npn transistor and the base of the second npn transistor; and
a first resistor between the collector of the second npn transistor and the base of the first npn transistor.

3. The contactor control circuit (140) as claimed in claim 2, wherein the delay circuit (141) further includes:
a second resistor between a voltage terminal to which a driving voltage is applied and the collector of the first npn transistor;
a third resistor between the voltage terminal and the base of the second npn transistor;
a fourth resistor between the voltage terminal and the collector of the second npn transistor; and
a fifth resistor between an output terminal of the second inverting circuit (145) that outputs the inverted abnormal signal and the base of the first npn transistor.

4. The contactor control circuit (140) as claimed in claim 2 or 3, wherein the delay circuit (141) further includes a sixth resistor between the base of the first npn transistor and a ground terminal,
wherein the ground terminal is connected to an emitter of the first npn transistor and an emitter of the second npn transistor.

5. The contactor control circuit (140) as claimed in claim 4, wherein the delay circuit (141) further includes:
a seventh resistor between an output terminal of the second inverting circuit (145) and a clock input terminal of the D flip-flop; and
a second capacitor between the clock input terminal of the D-flip-flop (142, 142a) and the ground terminal.

6. The contactor control circuit (140) as claimed in any of the preceding claims, wherein the D-flip-flop (142) includes a data input terminal for receiving the driving signal, a clock input terminal for receiving the inverted abnormal signal, an active-low set terminal for receiving the inverted driving signal, an active-low reset terminal for receiving the reset signal, and an output terminal for outputting the output signal.

7. A battery pack (100) comprising:
first and second pack terminals;
a battery (110) having at least one battery (110) cell;
a contactor connected between the battery (110) and the first pack terminal;
a microcontrol unit, MCU, (12, 120) that outputs a driving signal;
a power management integrated circuit, PMIC, (130) that monitors the status of the MCU (12, 120) and outputs an abnormal signal; and
a contactor control circuit (140) that receives the driving signal through a first input terminal, receives the abnormal signal through a second input terminal, and generates a control signal for controlling the contactor based on the driving signal and the abnormal signal,
wherein the contactor control circuit (140) includes:
a first inverting circuit (144) that generates an inverted driving signal by inverting the driving signal;
a second inverting circuit (145) that generates an inverted abnormal signal by inverting the abnormal signal;
a delay circuit (141) that outputs a high-level reset signal for a preset delay time if the inverted abnormal signal transitions from a low level to a high level;
a D-flip-flop (142) that generates an output signal based on the driving signal, the inverted driving signal, the inverted abnormal signal, and the reset signal; and
a logical sum circuit (143) that generates the control signal by performing a logical sum operation on the driving signal and the output signal.

8. The battery pack (100) as claimed in claim 7, wherein the MCU (120) is configured to output the driving signal at a high level to short-circuit the contactor and outputs the driving signal at a low level to disconnect the contactor, and
the PMIC (130) is configured to output the abnormal signal at a high level if the MCU (120) is in a normal state and outputs the abnormal signal at a low level if the MCU (120) is monitored in an abnormal state.

9. The battery pack (100) as claimed in claim 7 or 8, wherein the delay circuit (141) includes:
a first npn transistor controlled based on the inverted abnormal signal and the reset signal;
a second npn transistor outputting the reset signal from the collector;
a first capacitor between the collector of the first npn transistor and the base of the second npn transistor; and
a first resistor between the collector of the second npn transistor and the base of the first npn transistor.

10. The battery pack (100) as claimed in claim 9, wherein the delay circuit (141) further includes:
a second resistor between a voltage terminal to which a driving voltage is applied and the collector of the first npn transistor;
a third resistor between the voltage terminal and the base of the second npn transistor;
a fourth resistor between the voltage terminal and the collector of the second npn transistor;
and
a fifth resistor between an output terminal of the second inverting circuit (145) that outputs the inverted abnormal signal and the base of the first npn transistor.

11. The battery pack (100) as claimed in claim 9 or 10, wherein the delay circuit (141) further includes a sixth resistor between the base of the first npn transistor and a ground terminal,
wherein the ground terminal is connected to an emitter of the first npn transistor and an emitter of the second npn transistor.

12. The battery pack (100) as claimed in claim 11, wherein the delay circuit (141) further includes:
a seventh resistor between an output terminal of the second inverting circuit (145) and a clock input terminal of the D flip-flop; and
a second capacitor between the clock input terminal of the D-flip-flop (142) and the ground terminal.

13. The battery pack (100) as claimed in any of claims 7 to 12, wherein the D-flip-flop (142) includes a data input terminal for receiving the driving signal, a clock input terminal for receiving the inverted abnormal signal, an active-low set terminal for receiving the inverted driving signal, an active-low reset terminal for receiving the reset signal, and an output terminal for outputting the output signal.

14. A contactor control circuit (140a) comprising:
a first input terminal for receiving a driving signal;
a second input terminal for receiving an abnormal signal;
a first inverting circuit (144) that generates an inverted abnormal signal by inverting the abnormal signal;
a delay circuit (141) that outputs a high-level reset signal for a preset delay time if the inverted abnormal signal transitions from a low level to a high level;
a second inverting circuit (145) that generates an inverted reset signal by inverting the reset signal;
a D-flip-flop (142a) that generates an output signal based on the driving signal, the inverted abnormal signal, and the inverted reset signal; and
a logical sum circuit (143) that generates a control signal by performing a logical sum operation on the driving signal and the output signal.

15. The contactor control circuit (140a) as claimed in claim 14, wherein the D-flip-flop (142a) includes a data input terminal for receiving the driving signal, a clock input terminal for receiving the inverted abnormal signal, an active-high set terminal for receiving the driving signal, an active-high reset terminal for receiving the inverted reset signal, and an output terminal for outputting the output signal.
